(19) Europäisches Patentamt

European Patent Office

Office européen des brevets

(11) **EP 1 531 131 A1**

(12) **EUROPÄISCHE PATENTANMELDUNG**

(43) Veröffentlichungstag:
    **18.05.2005 Patentblatt 2005/20**

(51) Int Cl.[7]: **B65D 77/06**

(21) Anmeldenummer: **04026884.9**

(22) Anmeldetag: **12.11.2004**

(84) Benannte Vertragsstaaten:
    **AT BE BG CH CY CZ DE DK EE ES FI FR GB GR
    HU IE IS IT LI LU MC NL PL PT RO SE SI SK TR**
    Benannte Erstreckungsstaaten:
    **AL HR LT LV MK YU**

(30) Priorität: **13.11.2003 DE 10353199
               05.03.2004 DE 102004011373**

(71) Anmelder: **Busch, Rainer
    76889 Birkenhördt (DE)**

(72) Erfinder: **Busch, Rainer
    76889 Birkenhördt (DE)**

(74) Vertreter: **Castell, Klaus, Dr.-Ing.
    Patentanwaltskanzlei
    Liermann - Castell
    Gutenbergstrasse 12
    52349 Düren (DE)**

(54) **Transportverpackung und Verfahren zur Herstellung einer Transportverpackung**

(57) Eine Transportverpackung (1) mit einer Oberfläche aus Kunststoffmaterial (2) wird mittels einer darauf aufgebrachten Siliziumdioxidschicht (9) derart verbessert, dass die Permeation von Gasen aus der Verpackung stark verringert wird. Erfindungsgemäß wird hierzu auf dem Kunststoffmaterial in situ eine Siliziumdioxidbarriereschicht mittels einer chemischen Gasphasen-Abscheidung erzeugt. Für diese flammenpyrolytische Abscheidung werden vorteilhafter Weise Organosilane verwendet.

FIG. 1

EP 1 531 131 A1

**Beschreibung**

Die Erfindung betrifft eine Transportverpakkung mit einer Oberfläche aus Kunststoffmaterial und darauf aufgebrachtem Siliziumdioxid sowie ein Verfahren zur Herstellung einer Transportverpackung, bei dem auf eine Kunststoffoberfläche der Verpackung Siliziumdioxid aufgebracht wird.

Transportverpackungen mit einer Oberfläche aus Kunststoffmaterial sind in verschiedenen Ausführungsvarianten bekannt und haben sich gut bewährt. Als Beispiel sind sogenannte IBC Container zu nennen, die dazu dienen, Flüssigkeiten zu transportieren und zu lagern. Probleme bereitet bei vielen Anwendungsfällen die ungenügende Barrierewirkung von Kunststoffhohlkörpern, die eine Permeation von Lösungsmitteln, Gasen und Aromastoffen erlaubt.

Ein bekanntes Verfahren zur Erhöhung der Barrierewirkung von Kunststoffhohlkörpern ist das Bedampfen mit Metallen oder Metalloxyden im Vakuum. Außerdem werden Kunststoffhohlkörper auch mit Lakken wie Polysiloxanen in Kombination mit Aluminium und Zirkoniumdioxiden beschichtet. Des weiteren ist bekannt, Lacke in Kombination mit aminofunktionellen Nanopartikeln herzustellen und diesen Lacken als Pulver verfügbares Siliziumdioxid beizumischen.

Zum Abscheiden eines siliziumhaltigen Plasmapolymers auf der Transportverpackung wird auch die plasmaaktivierte chemische Dampfabscheidung oder die Plasmapolymerisation mit kalten Gasentladungen verwendet. Bei derartigen kalten Gasentladungen liegt die mittlere Temperatur nur wenig mehr als 100 Kelvin über der Umgebungstemperatur.

Eine Barrierewirkung kann auf Kunststoffhohlkörpern auch dadurch erzielt werden, dass mittels Niederdruck- oder Atmosphärendruck-Plasmatechnik durch eine Bedampfung im Vakuum eine Beschichtung mit Silazanen am Kunststoffhohlkörper erfolgt.

Die beschriebenen Verfahren haben jedoch den wesentlichen Nachteil, dass die Art des Aufbringens der Schicht sehr aufwendig und dadurch zeitintensiv und teuer ist. Bei der Bedampfung mit Metallen oder Metalloxiden wird zur Erzeugung einer Sperrschicht ein Vakuum benötigt und bei der Plasmapolymerisation mit kalter Gasentladung muss die Transportverpackung in ein elektrisches Wechselfeld eingebracht werden. Beim Aufbringen von Materialien mittels Düsen, wie bei der Atmosphärendruck-Plasmaerzeugung, wird mit einer begrenzten Aktivierungsbreite von 25 mm pro Plasmadüse gearbeitet. Daher müssen bei größeren Transportverpackungen eine Vielzahl an Düsen verwendet werden, was einen erhöhten technischen Aufwand bedeutet.

Die Aufgabe der vorliegenden Erfindung ist es, eine verbesserte und günstiger herstellbare Beschichtung zur Herstellung von Barriere- oder Permeationschutzschichten für Transportverpackungen bereit zu stellen.

Diese Aufgabe wird dadurch gelöst, dass das auf das Kunststoffmaterial der Transportverpackung aufgebrachte Siliziumdioxid von einer in situ erzeugten Siliziumdioxid-Barriereschicht gebildet ist.

Erfindungsgemäß wird die Transportverpackung mit amorphem Silikat beschichtet. Zur Beschichtung dient eine chemische Gasphasen-Abscheidung, die auch als Combustion Chemical Vapor Deposition (CCVD) bezeichnet wird. Mit dieser chemischen Verbrennungsgasphasen-Abscheidung wird eine Siliziumdioxidschicht auf der Oberfläche des Kunststoffinaterials erzeugt. Hierdurch wird die Oberfläche wie beispielsweise die Oberfläche eines HD-PE Hohlkörpers hermetisch versiegelt.

Durch die chemische Gasphasen-Abscheidung wird es erstmals möglich, neben einer günstig herstellbaren Permeationsschutzschicht auch eine Oberflächenspannung von über 50 mN / m zu erzeugen. Die Oberflächenspannung ist eine mechanische Grenzflächenenergie, die an der Grenzfläche einer Oberfläche wirkt und bestrebt ist, diese Oberfläche zu minimieren. Die Oberflächenspannung ist definiert als die auf der Oberfläche wirksame Oberflächenenergie. Sie entsteht aus der gegenseitigen Anziehungskraft der Moleküle oder Atome, aus denen die oberflächenbildende Phase aufgebaut ist.

Daher ist es möglich, eine in situ erzeugte Siliziumdioxid Barriereschicht anhand der Oberflächenspannung nachzuweisen. Ein einfacher Nachweis für die Aufbringung einer Siliziumdioxidbarriereschicht liegt in der Messung des Kontaktwinkels. Hierbei kann für Schnellmessungen nach Zismanns die kritische Oberflächenspannung durch Messung mit Testtinte zum Nachweis der Barriereschicht dienen. Je nach den unterschiedlichen Messmethoden nach Wu und van Oss liegt die mittlere Oberflächenspannung von Polyethylen bei 36,1 bzw. 40,4 mN / m. Messungen nach Zismanns mit Testtinte zeigen nach Aufbringung der Siliziumdioxidbarriereschicht eine Oberflächenspannung von über 50 mN / m.

Ein breites Anwendungsgebiet für die Erfindung liegt im Bereich der stabilen Hohlkörper und hierbei sind Transportverpackungen von besonderem Interesse, die ein Volumen von über 450 l aufweisen. Derartige Transportverpackung aus Kunststoff erlauben es auf einfache Art und Weise Behälter bereit zu stellen, die insbesondere für den Transport von Flüssigkeiten geeignet sind. Derartige Behälter werden in großen Stückzahlen für den Transport und die Lagerung von Stoffen, die Lösungsmittel, Geruchsstoffe und flüchtige Kohlenwasserstoffe enthalten, eingesetzt. Hierzu zählen beispielsweise sogenannte Intermediate Bulk Container (IBC). Dies sind in der Regel 1000 l Kunststoffbehälter, die vorteilhafter Weise aus Polyolefinen hergestellt sind. Hierbei ist vor allem HD-PE zu nennen.

Besonders vorteilhaft für das erfindungsgemäße Verfahren ist es, wenn das Kunststoffmaterial Polyethylen ist.

Bei Hohlkörpern wird vorgeschlagen, dass das Siliziumdioxid auf einer Außenseite der Transportverpackung angeordnet ist. Es ist jedoch auch möglich, die Barriereschicht auf der Innenseite eines Kunststoffhohlkörpers anzuordnen.

Eine bevorzugte Ausführungsvariante sieht vor, dass das Kunststoffmaterial mit dem aufgebrachten Siliziumdioxid transluzent ist. Eine derartige Schicht erlaubt es, den Befüllungsgrad des Behälters zu erkennen, auch wenn der Behälter vollständig mit einer Barriereschicht versehen ist.

Kumulativ oder alternativ kann vorgesehen sein, dass auf die Oberfläche mit dem darauf aufgebrachten Siliziumdioxid ein vorzugsweise leitfähiger Lack aufgebracht ist. Ein derartiger Lack erleichtert die elektrostatische Ableitung und verhindert dadurch eine statische Aufladung der Transportverpackung.

Zur Stabilisierung und gegebenenfalls auch zur elektrischen Ableitung wird vorteilhafter Weise vorgesehen, dass die Transportverpackung in einem Metallkäfig angeordnet ist. Ein derartiger Metallkäfig schützt die Verpackung aus Kunststoffmaterial gegen mechanische Stöße und erleichtert die Erdung der Verpackung.

Verfahrensmäßig wird die Aufgabe mit einem Verfahren zur Herstellung einer Transportverpackung gelöst, bei dem auf eine Kunststoffoberfläche der Verpackung Siliziumdioxid aufgebracht wird, wobei eine Siliziumdioxidbarriereschicht auf der Kunststoffoberfläche in situ erzeugt wird.

Hierbei wird die Siliziumdioxidbarriereschicht vorzugsweise durch eine flammenpyrolytische Abscheidung erzeugt.

Positive Ergebnisse sind mit einer chemischen Gasphase-Abscheidung erzielt worden, bei welcher Organosilane wie zum Beispiel Tetrathoxysilane, Tetramethylsilane in Verbindung mit Alkanen wie Propan, unter Mischung mit Luft thermisch in eine Siliziumdioxidschicht überführt werden.

Besonders bevorzugt ist die Verwendung von Hexamethyldisiloxan. Bei der chemischen Gasphasen-Abscheidungsbehandlung wurden in situ Siliziumdioxid Nanopartikel erzeugt, die nach einmaligem Bestreichen der Oberfläche zu einer nahezu geschlossenen Siliziumdioxidschicht formierten.

Je nach Prozessvariation können asymmetrische Lagen von (Si-O-Si) und (Si-OH) sowie (Si-O-Si) erzeugt werden.

Beispielsweise bei der chemischen Gasphasen-Abscheidungsbehandlung mit Tetramethylsilan können die entstehenden Nebenprodukte als umweltfreundlich eingestuft werden, da nur $H_2O$ und $CO_2$ bei der Umwandlung zur Siliziumdioxidschicht auftreten:

$$Si(CH_3)_4 + 13\,O_2 + C_3H_8 \rightarrow SiO_2 + 10\,H_2O + 7\,CO_2$$

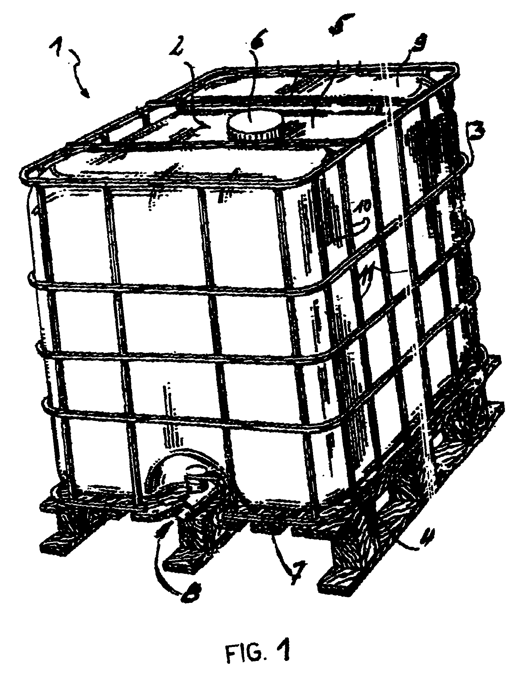

Die erfindungsgemäße Transportverpackung und das erfindungsgemäße Verfahren werden anhand des in der Figur gezeigten Intermediate Bulk Container (IBC) näher erläutert. Der Intermediate Bulk Container fasst 1000 1 und dient als Kunststoffgebinde zum Transport von flüssigen Füllstoffen der Chemischen-, Pharmazeutischen- und Lebensmittel-Industrie. Die Erfindung beschränkt sich jedoch nicht auf derartige Palettenbehälter, sondern betrifft beispielsweise auch Kunststofffässer, Kunststoffflaschen, Kunststoffkanister und Kunststoftheizöltanks die insbesondere aus Polyethylen oder Polypropylen hergestellt sind.

Der Palettenbehälter 1 besteht im Wesentlichen aus einer Kunststoffblase 2 einem umlaufenden Metallkäfig 3 und einer Palette 4.

Die Kunststoffblase 2 ist im vorliegenden Fall aus HD-PE gefertigt. Sie hat an ihrer oberen Seite 5 einen Schraubdeckel 6 und an ihrer Unterseite 7 eine Auslaufarmatur 8, die eine Entleerung des Palettenbehälters ermöglicht. Die Kunststoffblase 2 der Transportverpackung weist an ihrer Außenseite eine Siliziumdioxidbarriereschicht 9 auf. Diese Barriereschicht ist transluzent und erlaubt es, den Füllstand in dem Behälter von außen zu erkennen. Um die Kunststoffblase 2 herum ist ein Metallkäfig 3 angeordnet, der aus senkrechten und waagerechten, gekreuzten metallischen Hohlprofilen 10 und 11 gebildet ist.

Die aufgebrachte Siliziumdioxidbarriereschicht ermöglicht es, dass sogar bei Befüllung mit stark geruchsintensiven Stoffen nur noch eine kaum wahrnehmbare Geruchsbildung vorhanden ist.

Die Bestimmung der Barrierewirkung der Permeationsschutzschicht erfolgt durch Messungen an mit 250 ml Heizöl gefüllten HD-PE Flaschen. Die Flaschen werden hierbei mit Metallfolie versiegelt und in luftdicht abschließbaren Metallbehältern bei 40 °C anschließend vier Wochen gelagert. Die aufgebrachte $SiO_2$-Barriereschicht bewirkt, dass sich ein Gewichtsverlust des Füllguts von nur etwa 0,009 g / Tag einstellt.

Zum Aufbringen der Siliziumdioxidschicht wurde eine Brennerbreite von 100 mm verwendet. Es können jedoch Brennerbreiten bis über 1500 mm eingesetzt werden, um bei einmaligem Bestreichen der Kunststoffoberfläche eine möglichst große Oberflächenbreite zu beschichten.

Eine optimale Belegung der Oberfläche wurde durch zweimaliges Bestreichen der Oberfläche erzielt. Er hat sich herausgestellt, dass die hierbei gebildeten Siliziumdioxidpartikel zu Partikeln in der Größenordnung von 100 bis 300 nm agglomerieren. Ein geeignetes Brennergas enthält neben Alkanen, wie Propan und Butan, Luft und als Trägergas insbesondere Tetramethylsilan. Der Arbeitsdruck liegt bei 0,5 bar und die gemessene Flammentemperatur beträgt 1200 °C.

Beim Brennergas muss für eine ordnungsgemäße Verbrennung und eine ausreichende Luftzufuhr gesorgt werden. Das Verhältnis von Brennergasdurchsatz zu Trägergasdurchsatz kann im Bereich zwischen 135 bis 270 liegen. Eine besonders gleichmäßige Verteilung der Siliziumdioxidnanopartikel wurde bei einem Verhältnis von 210 l / min Brennergas zu 0,8 l / min Trägergas, dass heißt bei einer Verhältniszahl von etwa 263, erzielt. Hierbei wird von einer Standardeinstellung im Brenngas von Luft-Propan 25:1 bzw. Luft-Butan 13: 1 ausgegangen.

Ein vorteilhafter Abstand des Brenners zur Kunststoffoberfläche liegt bei 20 bis 60 mm. Im Ausführungsbeispiel wurde ein Abstand von 40 mm bei einer Bestreichungsgeschwindigkeit von 300 mm / s gewählt. Mit Bestreichungsgeschwindigkeiten von 200 bis 500 mm / s bei entsprechender Anpassung des Brenner- und Trägergasdurchsatzes wurden sehr gute Ergebnisse erzielt.

Neben der Verwendung von Tetramethylsilan oder Hexamethyldisiloxan wurden positive Ergebnisse auch mit Tetrathoxysilanen in Verbindung mit Alkanen wie Propan und Luft erzielt.

Durch variieren der Organosilangruppen, der Bestreichungsgeschwindigkeit sowie der Anzahl der Bestreichungsvorgänge und der Einstellung des Brenners können Barriereschichten aufgebaut werden, bei denen die Siliziumdioxidpartikel einen Durchmesser von 20 bis 75 nm aufweisen. Diese Werte können in Rasterelektronenmikroskopaufnahmen gemessen werden. Ein zweimaliges Bestreiches führt zu einer Agglomeration der Siliziumdioxidpartikel zu Partikelgrößen von 100 bis 300 nm. Bei dem erfindungsgemäßen Verfahren sind diese agglomerierten Partikel homogen auf der Kunststoffoberfläche verteilt, sodass eine gleichmäßige Sperrschicht erzeugt wird.

## Patentansprüche

1. Transportverpackung mit einer Oberfläche aus Kunststoffmaterial und darauf aufgebrachtem Siliziumdioxid, *dadurch gekennzeichnet, dass* das aufgebrauchte Siliziumdioxid von einer in situ erzeugten Siliziumdioxidbarriereschicht gebildet ist.

2. Transportverpackung insbesondere nach Anspruch 1, *dadurch gekennzeichnet, dass* die Oberfläche eine Oberflächenspannung von über 50 mN / m aufweist.

3. Transportverpackung nach einem der vorherigen Ansprüche, *dadurch gekennzeichnet, dass* die Transportverpackung ein stabiler Hohlkörper ist.

4. Transportverpackung nach einem der vorherigen Ansprüche, *dadurch gekennzeichnet, dass* die Transportverpackung ein Volumen von über 450 aufweist.

5. Transportverpackung nach einem der vorherigen Ansprüche, *dadurch gekennzeichnet, dass* das Kunststoffmaterial Polyethylen ist.

6. Transportverpackung nach einem der vorherigen Ansprüche, *dadurch gekennzeichnet, dass* das Siliziumdioxid auf einer Außerseite der Transportverpackung angeordnet ist.

7. Transportverpackung nach einem der vorherigen Ansprüche, *dadurch gekennzeichnet, dass* das Kunststoffmaterial mit dem aufgebrachten Siliziumdioxid transluzent ist.

8. Transportverpackung nach einem der vorherigen Ansprüche, *dadurch gekennzeichnet, dass* auf die Oberfläche mit dem derart aufgebrachten Siliziumdioxid ein vorzugsweise leitfähiger Lack aufgebracht ist.

9. Transportverpackung nach einem der vorherigen Ansprüche, *dadurch gekennzeichnet, dass* die Transportverpackung in einem Metallkäfig angeordnet ist.

10. Verfahren zur Herstellung einer Transportverpackung insbesondere nach einem der vorhergehenden Ansprüche, bei dem auf eine Kunststoffoberfläche der Verpackung Siliziumdioxid aufgebracht wird, *dadurch gekennzeichnet, dass* eine Siliziumdioxidbarriereschicht auf der Kunststoffoberfläche in situ erzeugt wird.

11. Verfahren nach Anspruch 10, *dadurch gekennzeichnet, dass* die Siliziumdioxidbarriereschicht durch eine flammenpyrolytische Abscheidung erzeugt wird.

12. Verfahren nach Anspruch 10 oder 11, *dadurch gekennzeichnet, dass* für die flammenpyrolytische Abscheidung Organosilane, vorzugsweise Hexamethyldisiloxan, verwendet werden.

13. Verfahren nach einem der Ansprüche 11 bis 12, *dadurch gekennzeichnet, dass* für die flammenpyrolytische Abscheidung Brennerbreiten von über 50 mm verwendet werden.

14. Verfahren nach einem der Ansprüche 11 bis 13, *dadurch gekennzeichnet, dass* für die flammenpyrolytische Abscheidung ein Verhältnis von Brennergas zu Trägergas mit einer Verhältniszahl von über 200 eingestellt wird.

FIG. 1

**Europäisches Patentamt**

# EUROPÄISCHER RECHERCHENBERICHT

Nummer der Anmeldung

EP 04 02 6884

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 5 670 224 A (IZU ET AL) 23. September 1997 (1997-09-23) * Spalte 4, Zeile 28 - Zeile 56; Anspruch 1 * ----- | 1,10 | B65D77/06 |
| A | EP 0 667 302 A (TETRA LAVAL HOLDINGS & FINANCE SA) 16. August 1995 (1995-08-16) * Spalte 2, Zeile 55 - Spalte 3, Zeile 23; Ansprüche 1,3,4 * ----- | 1,10 | |
| A | EP 0 668 219 A (TETRA LAVAL HOLDINGS & FINANCE SA) 23. August 1995 (1995-08-23) * Spalte 2, Zeile 54 - Spalte 3, Zeile 10 * * Spalte 4, Zeile 41 - Zeile 46; Ansprüche 1,2 * ----- | 1,10 | |
| A | GB 2 246 795 A (* BOWATER PACKAGING LIMITED) 12. Februar 1992 (1992-02-12) * Ansprüche 1,4,9 * ----- | 1,10 | RECHERCHIERTE SACHGEBIETE (Int.Cl.7) B65D |

Der vorliegende Recherchenbericht wurde für alle Patentansprüche erstellt

| Recherchenort | Abschlußdatum der Recherche | Prüfer |
|---|---|---|
| München | 10. Februar 2005 | Janosch, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

....................................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**          EP 04 02 6884

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

10-02-2005

| Im Recherchenbericht angeführtes Patentdokument | Datum der Veröffentlichung | Mitglied(er) der Patentfamilie | Datum der Veröffentlichung |
|---|---|---|---|
| US 5670224          A | 23-09-1997 | AU       696432 B2 | 10-09-1998 |
|  |  | AU      5536696 A | 07-11-1996 |
|  |  | CA      2218578 A1 | 24-10-1996 |
|  |  | DE     69625488 D1 | 30-01-2003 |
|  |  | DE     69625488 T2 | 30-10-2003 |
|  |  | EP      1206908 A1 | 22-05-2002 |
|  |  | EP      1252822 A2 | 30-10-2002 |
|  |  | EP      0840551 A1 | 13-05-1998 |
|  |  | JP     11504072 T | 06-04-1999 |
|  |  | WO      9632846 A1 | 24-10-1996 |
|  |  | US      5411591 A | 02-05-1995 |
|  |  | AU      5598194 A | 08-06-1994 |
|  |  | CA      2146369 A1 | 26-05-1994 |
|  |  | CA      2264371 A1 | 26-05-1994 |
|  |  | DE     69327725 D1 | 02-03-2000 |
|  |  | DE     69327725 T2 | 21-06-2000 |
|  |  | DE     69331291 D1 | 17-01-2002 |
|  |  | DE     69331291 T2 | 08-08-2002 |
|  |  | EP      0667921 A1 | 23-08-1995 |
|  |  | EP      0931853 A2 | 28-07-1999 |
|  |  | JP      3471356 B2 | 02-12-2003 |
|  |  | JP      8509264 T | 01-10-1996 |
|  |  | JP   2004003033 A | 08-01-2004 |
|  |  | WO      9411544 A1 | 26-05-1994 |
| EP 0667302          A | 16-08-1995 | CH       687614 A5 | 15-01-1997 |
|  |  | AU      1156995 A | 17-08-1995 |
|  |  | CA      2141832 A1 | 05-08-1995 |
|  |  | EP      0667302 A1 | 16-08-1995 |
|  |  | JP      7257585 A | 09-10-1995 |
|  |  | US      5721027 A | 24-02-1998 |
| EP 0668219          A | 23-08-1995 | CH       687613 A5 | 15-01-1997 |
|  |  | AU      1156895 A | 17-08-1995 |
|  |  | CA      2141834 A1 | 05-08-1995 |
|  |  | EP      0668219 A1 | 23-08-1995 |
|  |  | JP      7257567 A | 09-10-1995 |
| GB 2246795          A | 12-02-1992 | GB      2210826 A | 21-06-1989 |
|  |  | GB      2246794 A ,B | 12-02-1992 |

EPO FORM P0461

Für nähere Einzelheiten zu diesem Anhang : siehe Amtsblatt des Europäischen Patentamts, Nr.12/82